# EUROPEAN PATENT APPLICATION

(11) **EP 4 641 642 A1**
(43) Date of publication of application: **29.10.2025**
(21) Application number: 23906478.5
(22) Date of filing: 31.10.2023
(51) Int. Cl.: H01L 29/78, H01L 21/329, H01L 21/76, H01L 21/822, H01L 21/8234, H01L 27/04, H01L 27/06, H01L 29/06, H01L 29/12, H01L 29/739, H01L 29/861, H01L 29/866, H01L 29/868, H02M 1/00

(54) **ACTIVE CLAMP CIRCUIT AND SEMICONDUCTOR DEVICE**

(30) Priority: 22.12.2022 JP 2022205748
(71) Applicant: Shindengen Electric Manufacturing Co., Ltd., Tokyo 100-0004 (JP)
(72) Inventor: ITO, Hiromi, Asaka City, Saitama 3518503 (JP)
(74) Representative: Liesegang, Eva
(86) International application number: PCT/JP2023/039318
(87) International publication number: WO 2024/135106

(57) **Abstract**

An active clamp circuit 10 according to the present invention includes a clamp voltage control use switch 20 where first main switch is electrically connected to a main electrode of a main switch Q1 and a second main switch is electrically connected to a control electrode of the main switch Q1; and a clamp voltage decision part where one terminal of the clamp voltage decision part 30 is electrically connected to a first main electrode of the clamp voltage control switch 20 and the other terminal is electrically connected to a control electrode of the clamp voltage control use switch 20, wherein the clamp voltage decision part 30 had a plurality of sets 31 each is constituted of a temperature characteristic adjustment resistor 32, a Zener diode 33, and a diode 34, and the sets 31 are connected in series. The active clamp circuit 10 according to the present invention can clamp a voltage by absorbing a surge voltage and can perform an operation of a switching circuit even in a case where a large-sized diode is not used and hence, it is possible to make the operation of the switching circuit more stable.

## Description

### Technical Field

The present invention relates to an active clamp circuit and a semiconductor device.

### Background Art

In a switching circuit, (particularly a high-frequency switching circuit), a surge voltage is generated at the time of switching by a parasitic inductor of a wiring. To prevent a drawback such as breaking of a main switch caused by this surge voltage, conventionally, various countermeasures have been taken.

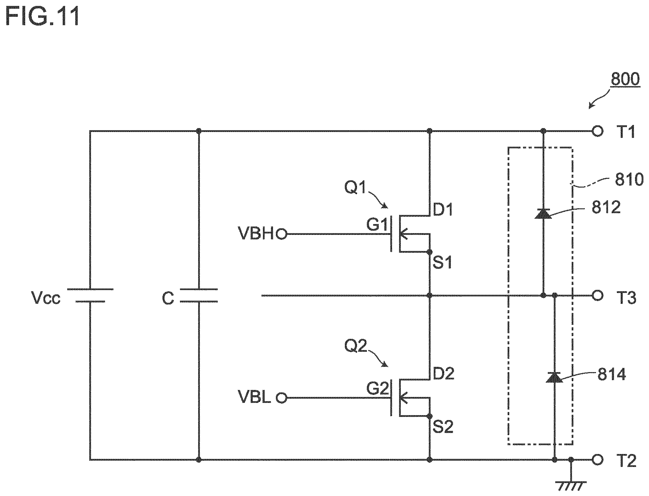

Fig. 11 is a circuit diagram illustrating a conventional first switching circuit 800. In Fig. 11, symbol Vcc indicates an external power source, symbol C indicates an input capacitor, symbols T1, T2, T3 indicate output terminals, symbols VBH, VBL indicate terminals provided for transmitting a signal for turning on or off a main switch to gate electrodes G1, G2 of main switches Q1, Q2.

In a conventional first switching circuit 800, in a case where clamp of a surge voltage at the time of switching is desired, it is necessary to add a clamp circuit 810 that is connected in parallel to the first main switch Q1 and the second main switch Q2 respectively to clamp diodes 812, 814 that have a withstand voltage slightly lower or substantially equal to withstand voltages of Q1, Q2. An anode electrode of the clamp diode 812 is connected to a node between the first main switch Q1 and the second main switch Q2, and a cathode electrode of the clamp diode 812 is connected to a drain electrode D1 of the first main switch Q1. An anode electrode of the clamp diode 814 is connected to a source electrode S2 of the second main switch Q2, and a cathode electrode of the clamp diode 814 is connected to a node between the first main switch Q1 and the second main switch Q2.

According to the conventional first switching circuit 800, the first switching circuit 800 includes the clamp diodes 812, 814 and hence, a surge voltage is absorbed by the clamp diodes 812, 814 so that a drain-source voltage of the first main switch Q1 and the second main switch Q2 can be clamped.

### Citation List

### Patent Literature

Japanese Patent No. 4054155

### Summary of Invention

### Technical Problem

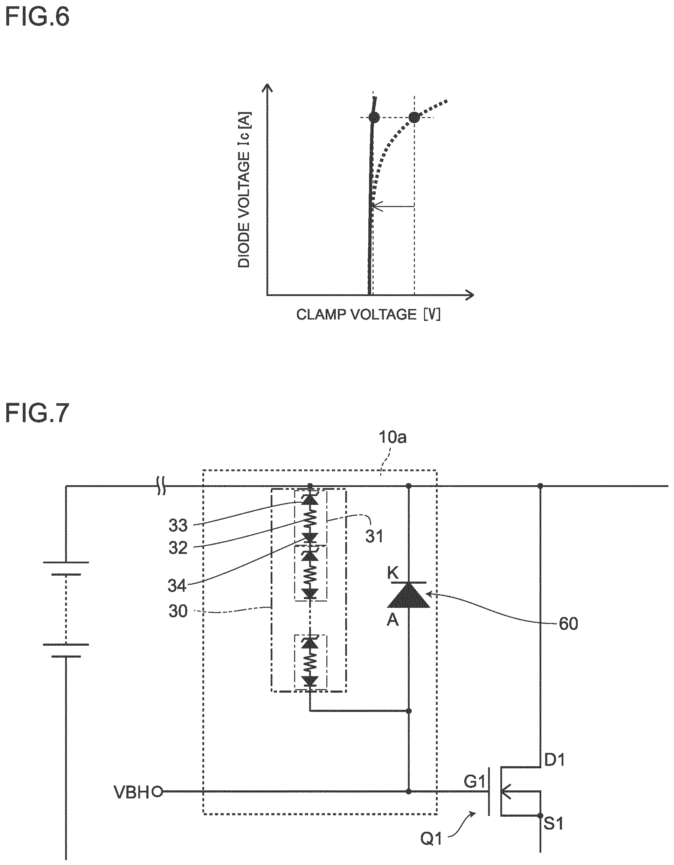

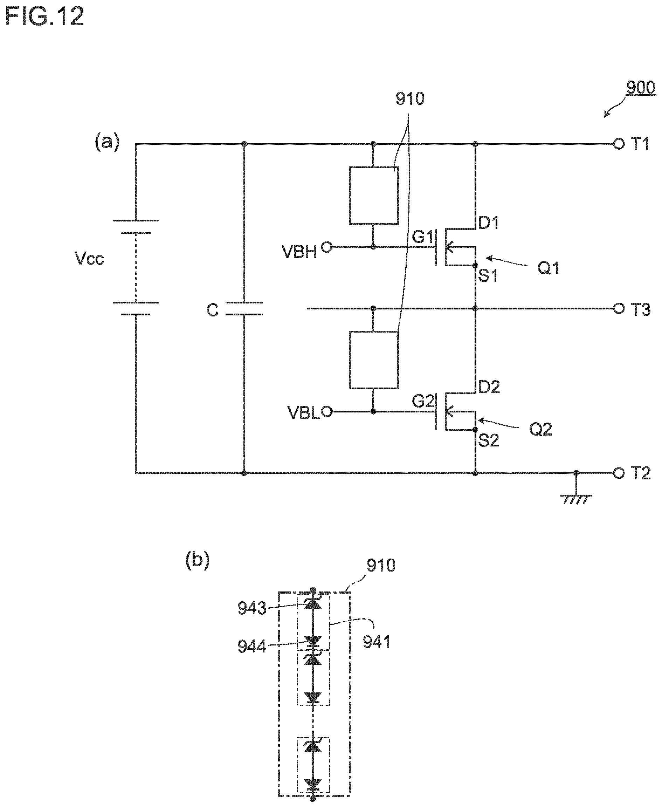

However, in the conventional first switching circuit 800, a drain-source voltage is clamped by bypassing currents that flow into the main switches Q1, Q2 into the clamp circuit 810 and hence, a current that flows into the clamp circuit 810 becomes large. As a result, it is necessary to provide a diode that can withstand a large current as the clamp diodes 812, 814 used in the clamp circuit 810 thus giving rise to a drawback that a large-sized diode becomes necessary. Further, a large current flows into the clamp diodes 812, 814 and hence, a change in a clamp voltage (see a broken line in Fig. 6) due to an operation resistance (impedance) of the clamp diodes 812, 814 is increased, and a rise in temperature of the clamp diodes 812, 814 is increased and hence, a change in a clamp voltage is increased. Accordingly, a function of clamping a surge voltage is not operated as expected thus giving rise to a drawback that an operation of the switching circuit becomes unstable. In view of the above, conventionally, there has been known a conventional second switching circuit 900 where an active clamp circuit 910 is provided between drain electrode D1, D2 and gate electrodes G1, G2 of main switches Q1, Q2 (see Fig. 12(a), for example, see Patent Literature 1).

Fig. 12 is a circuit diagram illustrating a conventional second switching circuit 900. In the conventional second switching circuit 900, an active clamp circuit 910 includes a plurality of sets 941 where a Zener diode 943 and a diode 944 are connected to each other with opposite characteristics (see Fig. 12 (b)).

In the conventional second switching circuit 900, when a drain-source voltage of a main switch Q1 (Q2) becomes larger than a voltage obtained by adding a Zener voltage of the Zener diode 943, a forward voltage VF of the diode 944 and a threshold voltage VTH of the gate electrode G1 (G2) of the main switch Q1 (Q2), a feedback capacitance of the main switch Q1, (Q2) is charged, and the main switch Q1 (Q2) that is in an OFF state at a timing that the drain-source voltage starts to increase is again turned on. As a result, the main switch Q1 (Q2) allows the flow of a drain current in a state where the drain-source voltage is applied and hence, a surge voltage can be absorbed in a state where a current that flows into the clamp circuit is small compared to the conventional first switching circuit 800.

In the technical field of an inverter circuit, a power source and the like, there has been a demand for an active clamp circuit capable of making a current that flows into a clamp diode further smaller thus further stabilizing an operation of a switching circuit.

The present invention has been made in view of the above-mentioned circumstances, and it is an object of the present invention to provide an active clamp circuit and a semiconductor device capable of clamp a voltage by absorbing a surge voltage even when a large-sized diode is not used, and capable of further stabilizing an operation of a switching circuit.

### Solution to problem

A first active clamp circuit according to the present invention is an active clamp circuit that is connected between a control electrode and a main electrode of a main switch and is configured to control a clamp voltage of the main switch, the active clamp circuit including: a clamp voltage control use switch that includes a first main electrode, a second main electrode and a control electrode, wherein the second main electrode is electrically connected with the main electrode of the main switch, the first main electrode is electrically connected with the control electrode of the main switch, and a clamp voltage decision part where one terminal of the clamp voltage decision part is electrically connected to the second main electrode of the clamp voltage control use switch and the other end of the clamp voltage decision part is electrically connected to the control electrode of the clamp voltage control use switch, wherein the clamp voltage decision part includes a plurality of sets each being constituted of a temperature characteristic adjustment resistor, a Zener diode connected to one end of the temperature characteristic adjustment resistor, and a diode connected to the other end of the temperature characteristic adjustment resistor such that the diode has an opposite characteristic with respect to the Zener diode, the set being connected in series.

A second active clamp circuit according to the present invention is an active clamp circuit that is connected between a control electrode and a main electrode of a main switch and is configured to control a clamp voltage of the main switch, the active clamp circuit including: a bypass diode that includes an anode electrode and a cathode electrode, wherein the anode electrode is electrically connected with the control electrode of the main switch, and the cathode electrode is electrically connected with the main electrode of the main switch, and a clamp voltage decision part where one terminal of the clamp voltage decision part is electrically connected to the cathode electrode of the bypass diode and the other terminal of the clamp voltage decision part is electrically connected to the anode electrode of the bypass diode and the control electrode of the main switch, wherein the clamp voltage decision part includes a plurality of sets each being constituted of a temperature characteristic adjustment resistor, a Zener diode connected to one end of the temperature characteristic adjustment resistor, and a diode connected to the other end of the temperature characteristic adjustment resistor such that the diode has an opposite characteristic with respect to the Zener diode, the set being connected in series.

A first semiconductor device according to the present invention is a semiconductor device that forms an active clamp circuit that is connected between a control electrode and a main electrode of a main switch and is configured to control a clamp voltage of the main switch, and is formed on a semiconductor base body on which a device region and a withstand voltage separation region that is formed around the device region are defined from each other, wherein the semiconductor device includes, in the device region, the semiconductor base body, a first main electrode that is formed on a surface of the semiconductor base body on a front surface side, a gate pad that is formed on the surface of the semiconductor base body on the front surface side, and is spaced apart from the first main electrode, and a second main electrode that is formed on a surface of the semiconductor base body on a back surface side, the semiconductor device includes an MOS structure that is formed in a region in which the first main electrode is formed, and the semiconductor device includes, in the withstand voltage separation region, the semiconductor base body, the second main electrode that is formed on the surface of the semiconductor base body on the back surface side, an insulation film formed on the surface of the semiconductor base body, and a clamp voltage decision part where, on the insulation film, in a region that surrounds the device region as viewed in a plan view, a plurality of first first-conductive-type region and a plurality of first second-conductive-type region are alternately disposed adjacently to each other, wherein one end of the clamp voltage decision part is electrically connected to the gate pad, and the other end of the clamp voltage decision part is electrically connected to the second main electrode, and in the clamp voltage decision part, a total dopant amount of the first first-conductive-type region sandwiched by two first second-conductive-type regions is smaller than a total amount of one of two first second-conductive-type regions disposed adjacently to the first first-conductive-type region, and is also smaller than a total amount of the other of two first second-conductive-type regions disposed adjacently to the first first-conductive-type region.

A second semiconductor device according to the present invention is a semiconductor device that forms an active clamp circuit that is connected between a control electrode and a main electrode of a main switch and is configured to control a clamp voltage of the main switch, and is formed on a semiconductor base body on which a device region and a withstand voltage separation region that is formed around the device region are defined from each other, wherein the semiconductor device includes, in the device region, the semiconductor base body, a first main electrode that is formed on a surface of the semiconductor base body on a front surface side, and a second main electrode that is formed on a surface of the semiconductor base body on a back surface side, a diode structure that is formed in a region in which the first main electrode is formed, and the semiconductor device includes, in the withstand voltage separation region, the semiconductor base body, the second main electrode that is formed on the surface of the semiconductor base body on the back surface side, and an insulation film formed on the surface of the semiconductor base body, and a clamp voltage decision part where, on the insulation film, in a region that surrounds the device region as viewed in a plan view, a plurality of first first-conductive-type region and a plurality of first second-conductive-type region are alternately disposed adjacently to each other, wherein one end of the clamp voltage decision part is electrically connected to the first main electrode, and the other end of the clamp voltage decision part is electrically connected to the second main electrode, and in the clamp voltage, a total dopant amount of the first first-conductive-type region sandwiched by two first second-conductive-type regions is smaller than a total amount of one of two first second-conductive-type regions disposed adjacently to the first first-conductive-type region, and is also smaller than a total amount of the other of two first second-conductive-type regions disposed adjacently to the first first-conductive-type region.

### Advantageous effects of the present invention

According to the first active clamp circuit of the present invention, the first active clamp circuit includes: the clamp voltage control use switch; and the clamp voltage decision part where one terminal of the clamp voltage decision part is electrically connected to the second main electrode and the other terminal of the clamp voltage decision part is electrically connected to the control electrode. As a result, in the same manner as the conventional switching circuit, a surge voltage can be absorbed. Further, this clamp voltage control use switch has a function as a driver that transmits an ON signal to the control electrode of the main switch. Accordingly, a drive current is small and, at the same time, a current that flows into the clamp voltage decision part that decides an OFF voltage that becomes a trigger can be also made small. Further, during a period that a surge voltage is generated by turning on the clamp voltage control use switch or the main switch, the main switch can be used as a voltage clamp use current path and hence, it is unnecessary to use a large-sized diode.

According to the second active clamp circuit of the present invention, the second active clamp circuit includes: the bypass diode; and the clamp voltage decision part where one terminal of the clamp voltage decision part is electrically connected to the cathode electrode of the bypass diode and the other terminal of the clamp voltage decision part is electrically connected to the anode electrode of the bypass diode and the control electrode of the main switch. As a result, in the same manner as the conventional switching circuit, a voltage can be clamped by absorbing a surge voltage. Further, a current that flows into the clamp voltage decision part can be also made small. Further, during a period that a surge voltage is generated by turning on the main switch, the main switch can be used as a voltage clamp use current path and hence, it is unnecessary to use a large-sized diode.

Further, according to the first and second active clamp circuits of the present invention, the active clamp circuit includes: the clamp voltage control use switch or the bypass diode and the clamp voltage decision part. Accordingly, as described above, a current that flows into the clamp circuit becomes small and hence, a dynamic resistance (dynamic impedance) of the Zener diode becomes small whereby a change in a clamp voltage (see a broken line in Fig. 6) brought about by the dynamic resistance (dynamic impedance) of the Zener diode becomes small. Further, a current that flows into the clamp circuit becomes small and hence, the rise in temperature of the Zener diode becomes small whereby a change in clamp voltage can be made small. Accordingly, it is possible to make the active clamp circuit operate a function of clamping a surge voltage as designed and hence, it is possible to make the operation of the switching circuit stable.

Further, according to the first and second active clamp circuits of the present invention, the clamp voltage decision part has a temperature characteristic adjustment resistor. Accordingly, an effect of a temperature characteristic of a forward voltage (a characteristic that a resistance is decreased with respect to rise in temperature) of the diode is cancelled by a temperature characteristic of the temperature characteristic adjustment resistance (a characteristic that a resistance is increased with respect to rise in temperature) and hence, a change based on temperature of a clamp voltage can be suppressed.

According to the first semiconductor device of the present invention, the MOS structure is formed in the region where the first main electrode is formed, and the plurality of first first-conductive-type regions and the plurality of first second-conductive-type regions are disposed alternately with each other in the withstand voltage separation region. Accordingly, it is possible to provide the active clamp circuit that includes: the clamp voltage control switch; and the clamp voltage decision part where one terminal of the clamp voltage decision part is electrically connected with the first main electrode of the clamp voltage control use switch and the other terminal of the clamp voltage decision part is electrically connected with the control electrode of the clamp voltage control use switch. Accordingly, in the same manner as the first active clamp circuit, a surge voltage can be absorbed. Further, this clamp voltage control-use switch (MOS structure) has a function as a driver for transmitting an ON signal to the control electrode of the main switch and hence, a drive current is small and, at the same time, a current that flows into the clamp voltage decision part that decides an OFF voltage that becomes a trigger can be also made small. On the other hand, the main switch can be used as a current path for voltage clamping during a period that a surge voltage is generated when the clamp voltage control switch or main switch is turned on, and hence, it is unnecessary to use a large-sized diode.

According to the second semiconductor device of the present invention, the diode structure is formed in the region where the first main electrode is formed, and the plurality of first first-conductive-type regions and the plurality of first second-conductive-type regions are disposed alternately adjacently to each other in the withstand voltage separation part. Accordingly, it is possible to provide the active clamp circuit that includes: the bypass diode; and the clamp voltage decision part where one terminal of the clamp voltage decision part is electrically connected with the first main electrode of the bypass diode and the other terminal of the clamp voltage decision part is electrically connected with the second electrode of the bypass diode. Accordingly, a voltage can be clamped by absorbing a surge voltage. Further, a current that flows into the clamp voltage decision part can be also made small and hence, the main switch can be used as a current path for voltage clamping during a period that a surge voltage is generated when the main switch is turned on. Accordingly, it is unnecessary to use a large-sized diode.

Further, according to the first and second semiconductor devices of the present invention, the MOS structure or the diode structure is formed in the region where the first main electrode is formed, and the clamp voltage decision part where the plurality of first first-conductive-type regions and the plurality of first second-conductive-type regions are alternately disposed adjacently to each other is disposed in the withstand voltage separation region and hence, it is possible to constitute the clamp voltage control use switch and the clamp voltage decision part. Accordingly, a current that flows into the active clamp circuit and the Zener diode becomes small and hence, an operation resistance (impedance) of the Zener diode becomes small whereby a change in clamp voltage (see a broken line in Fig. 6) brought about by the operation resistance (impedance) of the Zener diode can be made small. Further, the rise in temperature of the Zener diode becomes small and hence, a change in clamp voltage brought about by the rise in temperature of the Zener diode can be made small. Accordingly, a function of clamping a surge voltage can be operated as designed it is possible to make the operation of the switching circuit stable.

Further, according to the first and second semiconductor devices of the present invention, in the clamp voltage decision part, a total dopant amount in the first first-conductive-type region sandwiched between two first second-conductive-type regions is smaller than a total dopant amount of one two first second-conductive-type regions disposed adjacently to the first first-conductive-type regions, and is also smaller than a total dopant amount of the other of two first second-conductive-type regions disposed adjacently to the first first-conductive-type regions. Accordingly, the inner resistance in the first first-conductive-type region can be set larger than the inner resistance in the first second-conductive-type region and hence, the inner resistance of the first first-conductive-type region can be used as the temperature characteristic adjustment resistance of the clamp voltage decision part. Accordingly, an effect of a temperature characteristic of a forward voltage (a characteristic that a resistance is decreased with respect to rise in temperature) of the diode formed between the first first-conductive-type region and the first second-conductive-type region is cancelled by a temperature characteristic of the inner resistance (a characteristic that the inner resistance is increased with respect to the rise in temperature) of the first first-conductive-type region and hence, a change based on temperature of a clamp voltage can be suppressed.

### Brief Description of Drawings

Fig. 1 is a circuit diagram illustrating a switching circuit 1 and an active clamp circuit 10 according to an embodiment 1.
Fig. 2 is a view and graphs illustrating a resistance value of a temperature characteristic adjustment resistor 32, a forward voltage of a diode 34, a Zener voltage of a Zener diode 33, and a temperature characteristic of a clamp voltage of the active clamp circuit 10.
Fig. 3 is a plan view provided for describing a semiconductor device 100 according to the embodiment 1.
Fig. 4 is a cross-sectional view taken along a line A-A in Fig. 3.
Fig. 5 is a cross-sectional view taken along a line **B-**B in Fig. 3.
Fig. 6 is a schematic graph illustrating the relationship between a clamp voltage of the active clamp circuit and a current flow into the diode.
Fig. 7 is a circuit diagram illustrating an active clamp circuit 10a according to an embodiment 2.
Fig. 8 is a plan view provided for describing a semiconductor device 200 according to the embodiment 2.
Fig. 9 is a cross-sectional view provided for describing the semiconductor device 200 according to the embodiment 2.
Fig. 10 is a view provided for describing an active clamp circuit 10b and a semiconductor device 101 according to an embodiment 3.
Fig. 11 is a circuit diagram illustrating a conventional first switching circuit 800.
Fig. 12 is a circuit diagram illustrating a conventional second switching circuit 900.

### Description of Embodiments

An active clamp circuit and a semiconductor device according to the present invention are described based on embodiments illustrated in the drawings. The embodiments described hereinafter are not intended to limit the invention called for in Claims. Further, it is not always the case that all of various constitutional elements described in the embodiments and the combinations thereof are indispensable as means to solve the problems of the present invention.

### [Embodiment 1]

### 1. Configuration of switching circuit 1 according to embodiment 1

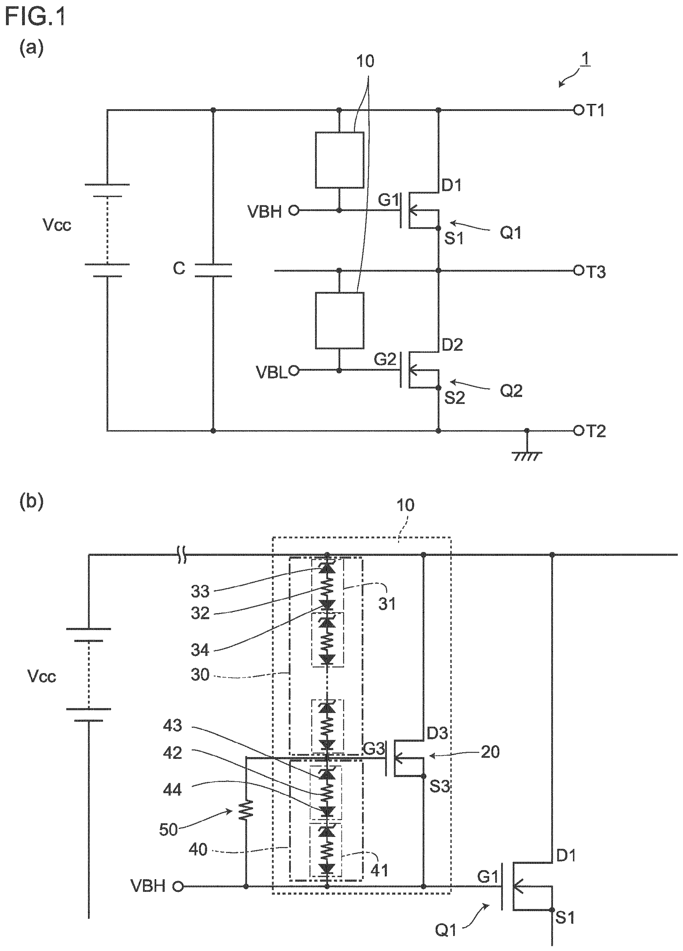

Fig. 1 is a circuit diagram illustrating a switching circuit 1 and active clamp circuits 10 according to the embodiment 1. Fig. 1(a) is a circuit diagram illustrating a switching circuit, and Fig 1(b) is a circuit diagram illustrating the active clamp circuit 10. Symbol 50 indicates a pull-down resistor, symbol Vcc indicates an external power source, symbols T1, T2, T3 indicate output terminals, and symbols VBH, VBL indicate terminals provided for transmitting signals for turning on or off main switches Q1, Q2 to gate electrodes G1, G2 of the main switches Q1, Q2.

The switching circuit 1 according to the embodiment 1 includes, as illustrated in Fig. 1(a), the first main switch Q1 on a high side, a second main switch Q2 on a low side that is connected in series with the first main switch Q1, an input capacitor C, and two active clamp circuits 10. As the main switches Q1, Q2, a suitable transistor such as a MOSFET, an IGBT can be used. A source electrode S1 of the first main switch Q1 is connected to a drain electrode D2 of the second main switch Q2, and a drain electrode D1 of the first main switch Q1 is connected to the external power source Vcc. A source electrode S2 of the second main switch Q2 is connected to a reference potential.

### 2. Configuration of active clamp circuits 10 according to embodiment 1

In both two active clamp circuits 10, one terminals are connected to the drain electrodes D1, D2 of the main switches Q1, Q2, and the other terminals are connected to gate electrodes G1, G2 of the main switches Q1, Q2. Both two active clamp circuits 10 have the same characteristics. Accordingly, hereinafter, the active clamp circuit 10 that is connected to the first main switch Q1 is described, and the description of the active clamp circuit 10 that is connected to the second main switch Q2 is omitted.

The active clamp circuit 10 clamps a drain-source voltage of the first main switch Q1. As illustrated in Fig. 1(b), the active clamp circuit 10 includes a clamp voltage control use switch 20, a clamp voltage decision part 30; and a gate protection part 40.

The clamp voltage control use switch 20 is a switch element having three terminals consisting of a drain electrode D3 (first main electrode), a source electrode S3 (second main electrode) and a gate electrode G3 (control electrode). In this embodiment 1, a MOSFET is used for forming the clamp voltage control use switch 20, an IGBT may be used, or other suitable switch elements may be used. In the clamp voltage control use switch 20, the drain electrode D3 is electrically connected to an external power source Vcc and the drain electrode D1 of the first main switch Q1, and the source electrode S3 is connected to the gate electrode G1 of the first main switch Q1.

One terminal of the clamp voltage decision part 30 is electrically connected to the drain electrode D3 of the clamp voltage control use switch 20, the external power source Vcc and the drain electrode D1 of the first main switch Q1, and the other terminal of the clamp voltage decision part 30 is electrically connected to the gate electrode G3 of the clamp voltage control use switch 20. The clamp voltage decision part 30 includes a plurality of sets 31 each constituted of a temperature characteristic adjustment resistor 32, a Zener diode 33 connected to one end of the temperature characteristic adjustment resistor 32, and a diode 34 connected to the other end of the temperature characteristic adjustment resistor 32 such that the diode 34 has a opposite characteristic against the Zener diode 33. The sets 31 are connected in series in a state where the Zener diode 33 is disposed on a drain electrode D3 side.

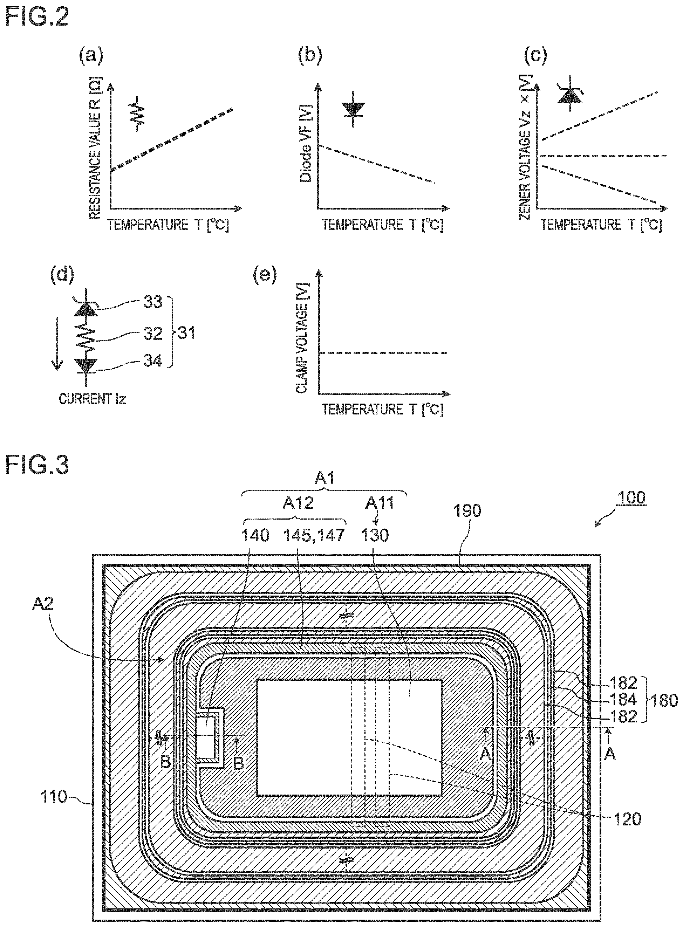

In the inside of the set of the plurality of (multiple stages) of sets 31 that constitute the clamp voltage decision part 30, by combining the temperature characteristic adjustment resistor 32 where resistance (a voltage drop caused by the resistance) has the positive correlation relationship with the rise in temperature, the diode 34 where a forward voltage has the negative correlation relationship with respect to the rise in temperature, and the Zener diode 33 that has the positive or negative correlation with respect to rise in temperature, a temperature coefficient to a voltage applied to the set 31 is adjusted so that, in the set 31, the temperature characteristics sets substantially fixed with respect to the rise in temperature (see Fig. 2 described later). In other words, the temperature characteristic adjustment resistor 32 has a temperature characteristic of reducing a change based on temperature of a voltage formed by superposing a Zener voltage of the Zener diode 33 of the set 31 having the temperature characteristic adjustment resistor 32 and a forward voltage of the diode 34.

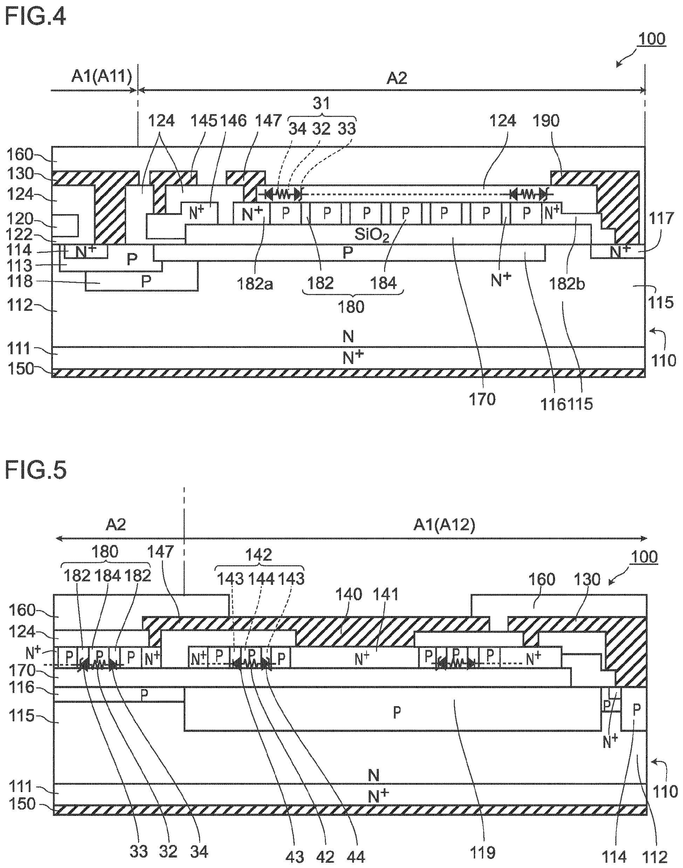

One terminal of the gate protection part 40 is connected to the gate electrode G3 of the clamp voltage control use switch 20, and the other terminal of the gate protection part 40 is connected to a source electrode S3 of the clamp voltage control use switch 20, and the gate electrode G1 of the main switch Q1. The gate protection part 40 includes a plurality of sets 41 constituted of a gate protection use temperature characteristic adjustment resistor 42, gate protection use Zener diode 43 connected to one terminal of the gate protection use temperature characteristic adjustment resistor 42, and a gate protection use diode 44 connected to the other terminal of the gate protection use temperature characteristic adjustment resistor 42 such that the gate protection use diode 44 has an opposite characteristic against the gate protection use Zener diode 43, and the gate protection use Zener diode 43 is connected with the gate electrode G3 side in series. The gate protection part 40 connects the necessary number of sets 41 in series such that the use voltage becomes a voltage not less than a gate drive voltage used and does not cause insulation breakdown of the gate oxide film (an electrostatic breakdown of a gate insulation film (see symbol 122 in Fig. 4) used in the gate electrode G3 of the clamp voltage control use switch 20 is prevented).

The active clamp circuit 10 is operated as follows. That is, when a drain-source voltage of the first main switch Q1, that is, a voltage set by the clamp voltage decision part 30 becomes "(a Zener voltage of the Zener diode 33 + forward voltage VF of the diode 34 + a voltage drop amount of the temperature characteristic adjustment resistor 32) × number of stages + a threshold voltage of the clamp voltage control use switch 20" or more, the clamp voltage control use switch 20 is turned on and hence, the suppression of the further increase of the voltage starts and, at the same time, the gate of the main switch Q1 is driven and hence, the main switch Q1 is also brought into an ON state thus suppressing the increase of a drain voltage. That is, voltage is brought into a voltage clamp state.

In this manner, the drain-source voltage of the first main switch Q1 can be clamped and, at the same time, a current that flows into the clamp voltage decision part 30 can be reduced.

### 3. temperature characteristic adjustment resistor 32 according to embodiment 1

Next, the temperature characteristic adjustment resistor 32 of the clamp voltage decision part 30 is described in detail. Fig. 2 is a drawing and graphs illustrating a resistance value R of the temperature characteristic adjustment resistor 32, a forward voltage VF of the diode 34, a Zener voltage Vz of the Zener diode 33 and a temperature characteristic of a clamp voltage of the active clamp circuit 10 according to the embodiment. Fig. 2(a) illustrates a temperature characteristic of the resistance value R of the temperature characteristic adjustment resistor 32, Fig. 2(b) illustrates a temperature characteristic of the forward voltage VF of the diode 34, Fig. 2(c) illustrates a temperature characteristic of the Zener voltage Vz of the Zener diode 33, Fig. 2(d) is the configuration of the set 31 of the clamp voltage decision part 30, Fig. 2 (e) illustrates a temperature characteristic of a clamp voltage of a clamp voltage decision part 30.

In the clamp voltage decision part 30, the temperature characteristic adjustment resistor 32, a Zener diode 33 and the set 31 of the diode 34 (see Fig. 2(d)) are connected in series in plural stages. Accordingly, by adding the resistance value R (a voltage drop by resistance) of the temperature characteristic adjustment resistor 32, the forward voltage VF of the diode 34, and the Zener voltage Vz of the Zener diode 33 to each other, a clamp voltage is decided. Accordingly, a temperature characteristic of the clamp voltage is also influenced by the respective temperature characteristics of the above-mentioned three constitutional elements.

The temperature characteristic of the forward voltage VF of the diode 34 is lowered in a rightward direction along with the increase of a temperature (see Fig. 2(b)). And hence, by using the temperature characteristic adjustment resistor 32 that has a temperature characteristic increased in a rightward direction along with the increase of a temperature, the diode 34 can possess a temperature characteristic where a change based on temperature of the forward voltage of the diode 34 is reduced. Accordingly, a change based on temperature of a clamp voltage of the clamp voltage decision part 30 can be reduced.

Further, the temperature characteristic of a Zener voltage Vz of the Zener diode 33 differs corresponding to a characteristic of the Zener diode (see Fig. 2(c)). Accordingly, by changing a gradient with respect to a change based on temperature of the temperature characteristic adjustment resistor 32 corresponding to a temperature characteristic of a Zener voltage Vz of a Zener diode 33, a change based on temperature of the clamp voltage of the clamp voltage decision part 30 can be further reduced and hence, a clamp voltage can be maintained substantially at a fixed value even when the clamp voltage becomes a high temperature (see Fig. 2(e)).

### 4. Configuration of semiconductor device 100 according to embodiment 1

Next, the device structure of the active clamp circuit 10 is described. In the conventional first switching circuit 800 and the conventional second switching circuit 900, it may be considered that the clamp circuit and the main switch Q1 are incorporated into one chip. However, there arises a demerit that a chip size of the main switch Q1 is increased accordingly. In view of the above, in the embodiment 1, the active clamp circuit 10 is formed in a chip different from the main switch Q1 thus preventing the chip size of the main switch Q1 from becoming large.

Fig. 3 is a plan view provided for describing the semiconductor device 100 according to the emeboidment1. With respect to the clamp voltage decision part 180, although the clamp voltage decision part 180 has the structure where a plurality of first N-type regions 182 and a plurality of first P-type regions 184 are disposed in an alternating manner adjacently to each other, to facilitate the description, only the first P-type region 184 on a most device region A1 side and the first N-type region 182 disposed adjacently to the first P-type region 184, the first P-type region 184 at an intermediate position, the first N-type region 182 disposed adjacently to the first P-type region 184 are illustrated, and the illustration is omitted with respect to other first P-type regions 184 and first N-type regions 182. In the same manner, only two gate electrodes 120 are described, and the illustration of other gate electrodes is omitted. Further, with respect to the source electrode 130 and the gate pad 140, pad parts for connection with the outside are indicated as blanks, and other parts (polysilicon parts) are indicated by hatching. Still further, in Fig. 3, it appears one gate wiring used. However, as illustrated in Fig. 4, the gate wiring is separated into a first gate wiring 145 and a second gate wiring 147. Fig. 4 is a cross-sectional view taken along a line A-A in Fig. 3.

As illustrated in Fig. 3, in the semiconductor device 100 according to the embodiment 1, a semiconductor base body 110 where a device region A1 formed in a center part and a withstand voltage separation region A2 formed surrounding the device region A1 are defined from each other is formed. A clamp voltage control use switch 20 is formed in the device region A1, and a clamp voltage decision part 30 is formed in the withstand voltage separation region A2. That is, the semiconductor device 100 according to the embodiment 1 is realized as a device where an active clamp circuit 10 that is connected between the gate electrode and the drain electrode of the main switches Q1, Q2, and controls clamp voltages of the main switches Q1, Q2 is formed.

### (1) Device region A1

The device region A1 is a region where the clamp voltage control use switch 20 is formed. That device region A1 is constituted of: an active region A11 (see Fig. 4) where an MOS structure is formed in a region that overlaps with the source region 130; and a peripheral region A12 (see Fig. 5) that is formed on a periphery of the active region A11, and in which the gate pad 140, the first gate wiring 145 and the second gate wiring 147 are formed.

### (1-1) Active region A11

The semiconductor device 100 according to the embodiment 1 includes, in the active region A11 of the device region A1, as illustrated in Fig. 3 and in Fig. 4, the semiconductor base body 110, the gate electrodes 120, gate insulation films 122, interlayer insulation films 124, source electrode 130 (first main electrodes), the drain electrodes 150 (second main electrodes), and a protective insulation film 160. The semiconductor device 100 according to the embodiment 1 is a planar gate type MOSFET having the gate electrodes 120, the gate insulation films 122 and the MOS structure of the semiconductor base body 110 in the region where the source electrodes 130 of the device region A1 are formed. The trench gate type MOSFET may be used in place of the planar gate type MOSFET.

As illustrated in Fig. 4, the semiconductor base body 110 includes: an N⁺-type low resistance semiconductor layer 111; an N-type drift layer 112 formed above the low resistance semiconductor layer 111; a P-type base region 113 formed in a predetermined region on a surface of the drift layer 112; and an N⁺-type source region 114 formed in a spaced-apart manner from the drift layer 112 at a part of a surface of the base region 113. Silicon can be used as a material of the semiconductor base body 110. However, it is also preferably used materials such as silicon carbide (SiC), gallium nitride (GaN), a gallium oxide (Ga₂O₃).

A thickness of a low resistance semiconductor layer 111 falls within a range of, for example, 100µm to 400µm, a dopant concentration of the low resistance semiconductor layer 111 falls within a range of1×10¹⁹cm⁻³ to 1×10²⁰cm⁻³, for example. A thickness of the drift layer 112 falls within a range of 5µm to 120µm, for example. A dopant concentration of the drift layer 112 falls within a range of 5×10¹³cm⁻³ to 1×10¹⁶cm⁻³, for example. A depth position of a deepest part of the base region 113 falls within a range of 0.5 µm to 4.0 µm, for example. A dopant concentration of the base region 113 falls within a range of 5×10¹⁶cm⁻³ to 1×10¹⁸cm⁻³, for example. A depth position of a deepest part of the source region 114 falls within a range of 0.1 µm to 1.5 µm, for example, and a dopant concentration of the source region 114 falls within a range of 5×10¹⁹cm⁻³ to 2×10²⁰cm⁻³, for example.

As illustrated in the region A1 in Fig. 4, the gate electrodes 120 are disposed over the semiconductor base body 110 by way of the gate insulation film 122. The gate electrodes 120 face the base regions 113 sandwiched between the source regions 114 and the drift layer 112 with the gate insulation films 122 sandwiched therebetween. As illustrated in Fig. 3, the gate electrodes 120 are arranged in a stripe shape in a state where the gate electrodes 120 longitudinally extend over the semiconductor base body 110 at a predetermined interval as viewed in a plan view. Both end portions of each gate electrode 120 is connected to the first gate wiring 145 via a lead wiring 146 described later (see Fig. 4).

The interlayer insulation film 124 is formed above and sides of the gate electrodes 120 thus insulating the gate electrodes 120 from the source electrodes 130. The interlayer insulation film 124 is an oxide film formed by a CVD method, for example. The interlayer insulation film 124 is an oxide film containing phosphorus or phosphorus and boron and having a thickness of 0.5 µm to 2.0 µm. However, the interlayer insulation film 124 may also use other suitable insulation films.

The source electrodes 130 are formed on the interlayer insulation film 124, and are connected to the source region 114 and the base region 113 on a surface of the semiconductor base body 110 via contact trenches or the like formed on the interlayer insulation film 124. The source electrode 130 is formed of an Al film or an Al alloy film (AlSi film, for example) and a thickness of the source electrode 130 is 1 µm to 10 µm (for example, 3 µm).

The drain electrode 150 is disposed on the entirety of a surface of the semiconductor base body 110 on a back surface side (on a surface of the low resistance semiconductor layer 111). The drain electrode 150 is formed of a stacked film formed by stacking a Ti layer, an Ni layer and an Au layer (or an Ag layer) from a semiconductor base body 110 side in this order. A thickness of the drain electrode 150 falls within a range of 0.2 µm to 1.5 µm (for example, 1 µm).

The protective insulation film 160 is formed over the entire surface of the semiconductor base body 110 except for a pad part of the source electrode 130 (a white rectangular part at the center in Fig. 3) and a dicing region where the gate pad 140 and the chip are separated from each other by dicing. A material of the protective insulation film 160 is, for example, polyimide.

### (1-2) Peripheral region A12

Fig. 5 is a cross-sectional view taken along a line B-B in Fig. 3. As illustrated in Fig. 3 and Fig. 5, the gate pad 140, the first gate wiring 145 and the second gate wiring 147 are disposed on the semiconductor base body 110. The interlayer insulation film 124 is formed on the gate lead wiring 146 and the gate protection part 142. As illustrated in Fig. 5, the gate pad 140 is disposed at a position outside one short side of the rectangular source electrode and at a position spaced apart from the source electrode 130. The first gate wiring 145 and the second gate wiring 147 are disposed so as to substantially surround the whole circumference of the source electrode 130 in a state where the first gate wiring 145 is disposed on an inner peripheral side and the second gate wiring 147 is disposed on an outer peripheral side (Fig. 3 and Fig. 4), and the first gate wiring 145 and the second gate wiring 147 are connected to the gate pad 140.

The gate pad 140 is disposed by way of a polysilicon layer 141 formed on a field insulation film 170 (see Fig. 3 and Fig. 5). The gate pad 140 is connected to the source electrode 130 via the polysilicon layer 141 and the gate protection part 142 described later. Further, the gate pad 140 is also connected to the first gate wiring 145 and the second gate wiring 147 (see Fig. 5 with respect to the connection between the second gate wiring 147 and the gate pad 140). The polysilicon layer 141 is formed, for example, by injecting n-type dopants into a polysilicon layer formed by a CVD method by an ion implantation method.

The first gate wiring 145 is disposed over the lead wiring 146 disposed over the interlayer insulation film 124 (See Fig. 4). The lead wiring 146 is connected with end portions of the gate electrodes 120 disposed in a stripe shape. The first gate wiring 145 is connected with the lead wiring 146, and is connected to the gate electrode 120 via the lead wiring 146. The lead wiring 146 is formed by introducing dopants into polysilicon.

The second gate wiring 147 is connected with a clamp voltage decision part 180 disposed in the withstand voltage separation region A2. The gate pad 140, the first gate wiring 145 and the second gate wiring 147 are formed collectively with the source electrode 130.

Further, in the peripheral region A12 of the device region A1, as illustrated in Fig. 5, the semiconductor device 100 according to this embodiment 1 includes: the semiconductor base body 110, the field insulation film 170, the gate protection part 142, the drain electrode 150, and the protective insulation film 160. The drain electrode 150 and the protective insulation film 160 have substantially the same configuration as the active region A11.

As illustrated in Fig. 5, the semiconductor base body 110 includes a N⁺-type low resistance semiconductor layer 111, an N-type semiconductor layer 115 disposed over the low resistance semiconductor layer 111, a P-type semiconductor layer 119. The N⁺-type low resistance semiconductor layer 111 has the same configuration as the low resistance semiconductor layer 111 in the active region A11. The N-type semiconductor layer 115 has the same structure as the drift layer in the active region A11. The P-type semiconductor layer 119 has substantially the same depth as the base region 113 in the active region A11.

A field insulation film 170 is an oxide film or other suitable insulation film formed on a surface of the semiconductor base body 110.

The gate protection part 142 is disposed over the field insulation film 170 in a region that surrounds the whole circumference of the gate pad 140 (the polysilicon layer 141 below the gate pad 140 in a strict meaning of the term) as viewed in a plan view. Accordingly, the gate pad 140 is electrically connected with the source electrode 130 via the gate protection part 142 (see a light side in Fig. 5) and, at the same time, the gate pad 140 is electrically connected with the first gate wiring 145 via the gate protection part 142 although not illustrated in the drawing.

In the gate protection part 142, at least one second N-type region 143 and at least two second P-type regions 144 are alternately disposed adjacently to each other. In the gate protection part 142, a total dopant amount of the second P-type region 144 sandwiched by two second N-type regions 143 is smaller than a total dopant amount of one of two second N-type regions 143 disposed adjacently to the second P-type region 144, and is also smaller than a total dopant amount of the other of two second N-type regions 143 disposed adjacently to the second P-type region 144. Accordingly, an inner resistance of the second P-type region 144 can be used as the gate protection use temperature characteristic adjustment resistor 42. Further, the gate protection use Zener diode 43 is constituted of the second P-type region 144 and the second N-type region 143 on one side, and the gate protection use diode 44 can be constituted of the second P-type region 144 and the second N-type region 143 on the other side.

### (2) Withstand voltage separation region A2

The withstand voltage separation region A2 is a region where the clamp voltage decision part 30 is formed.

As illustrated in Fig. 3 to Fig. 5, the semiconductor device 100 according to the embodiment 1 includes, in the withstand voltage separation region A2, the semiconductor base body 110, the field insulation film 170, the clamp voltage decision part 180, the channel stop electrode 190 and the drain electrode 150. The drain electrode 150 and the field insulation film 170 have substantially the same configuration as the device region A1. Further, the interlayer insulation film 124 is formed over the clamp voltage decision part 180.

The semiconductor base body 110 includes, in the withstand voltage separation region A2, the N⁺-type low resistance semiconductor layer 111, the N-type semiconductor layer 115 formed above the low resistance semiconductor layer 111, the P-type resurf region 116 formed on a surface of the N-type semiconductor layer 115, and the channel stop region 117. Further, the semiconductor base body 110 includes a P-type boundary semiconductor region 118 formed so as to cover an end portion of the base region 113 ranging from the device region A1 to the withstand voltage separation region A2. The N⁺-type low resistance semiconductor layer 111 has the same configuration as the low resistance semiconductor layer 111 in the device region A1. The N-type semiconductor layer 115 has the same structure as the drift layer 112 in the active region A11. A depth of the boundary semiconductor region 118 is set to a depth position deeper than the base region 113. However, the depth of the boundary semiconductor region 118 may be set to the same depth as the base region 113.

The resurf region 116 is formed in a region where the resurf region 116 overlaps with at least the clamp voltage decision part 180 in a state where a depth of the resurf region 116 is equal to or shallower than the P-type region 118. An end portion of the resurf region 116 is connected with the base region 113 and the P-type boundary semiconductor region 118 in the device region A1. The channel stop region 117 is the N⁺-type semiconductor region that is formed on an outermost peripheral surface of the semiconductor base body 110 and is connected with the channel stop electrode 190.

As illustrated in Fig. 3, the clamp voltage decision part 180 surrounds the whole circumference of the device region A1 as viewed in a plan view. As illustrated in Fig. 4, the clamp voltage decision part 180 is connected with the second gate wiring 147 on a device region A1 side, and is connected with the channel stop electrode 190 that is formed so as to have the same potential as the drain electrode 150 at an outermost peripheral side thereof. Accordingly, one end (the device region A1 side) of the clamp voltage decision part 180 is connected with the gate pad 140 via the second gate wiring 147, and the other end (the outermost peripheral side) of the clamp voltage decision part 180 is electrically connected with the drain electrode 150.

In the clamp voltage decision part 180, on the field insulation film 170, the plurality of first P-type regions 184 and the plurality of first N-type regions 182 are alternately arranged in an adjacently manner with each other. The clamp voltage decision part 180 has the structure that corresponds to the clamp voltage decision part 30 of the active clamp circuit 10. That is, the diode 34 is formed between one first P-type region 184 and the other first P-type region 184 on the device region A1 side, and the Zener diode 33 is formed between one first P-type region 184 and the other first P-type region 184 on the outer peripheral side.

The first N-type region 182 and the first P-type region 184 are formed by introducing P-type dopants or N-type dopants into respective predetermined regions with respect to the same polysilicon layer. In the clamp voltage decision part 180, a total dopant amount of the first P-type region 184 sandwiched by two first N-type regions 182 is smaller than a total dopant amount of one of two first N-type regions 182 disposed adjacently to the first P-type region 184, and is also smaller than a total dopant amount of the other of two first N-type regions 182 disposed adjacently to the first P-type region 184. Accordingly, an inner resistance of the first P-type region 184 is increased and hence, a temperature characteristic adjustment resistor 32 can be formed. In this embodiment 1, the clamp voltage decision part 180, the polysilicon layer 141, the lead wiring 146 and the gate protection part 142 are collectively formed.

In the clamp voltage decision part 180, an inner resistance of the first P-type region 184 that is sandwiched between two first N-type regions 182 has a temperature characteristic of cancelling a change based on temperature at a voltage obtained by superposing a forward voltage of a diode formed of the first P-type region 184 and the first N-type region 182 disposed adjacently on one side of the first P-type region 184, and a Zener voltage of a Zener diode formed of the first P-type region 184 and the first N-type region 182 disposed adjacently to the other side of the first P-type region 184. The inner resistance of the first P-type region 184 is decided based on dopant concentration of the first P-type region 184, a length of the first P-type region 184 in a direction along a current path (a length in the lateral direction in Fig. 4), and a cross-sectional area of the first P-type region 184 with respect to a current path (the cross-sectional area of a surface orthogonal to a current path) .

In the embodiment 1, dopant concentration in the first P-type region 184 is lower than dopant concentration in the first N-type region 182. Accordingly, carriers in the first P-type region 184 is decreased and hence, from a viewpoint of dopant concentration, an inner resistance of the first P-type region 184 is larger than an inner resistance of the first N-type region 182. A lateral width (a length in the radial direction = length of current path) of the first P-type region 184 illustrated in Fig. 3 and Fig. 5 is set longer than the lateral width of the first N-type region 182. Such a configuration is adopted due to following reason. It is not easy to strictly control the inner resistance by adjusting dopant concentration of P-type dopants introduced into dopant concentration in the first P-type region 184. Accordingly, a total dopant amount in the first P-type region 184 is adjusted by adjusting the lateral width (the length in the radial direction = the length of the current path) of the first P-type region 184. Accordingly, although the lateral width (the length in the radial direction = the length of the current path) of the first P-type region 184 is longer than the lateral width of the first N-type region 182, from a viewpoint of the inner resistance, the inner resistance of the first P-type region 184 is larger than the inner resistance of the first N-type region 182.

The channel stop electrode 190 is disposed on an outermost periphery of the semiconductor base body 110, and is formed so as to surround the whole circumference of the semiconductor base body 110, and is electrically connected with the drain electrode 150.

### 5. Advantageous effects of active clamp circuit 10 and semiconductor device 100 according to embodiment 1

According to the active clamp circuit 10 of the embodiment 1, the active clamp circuit 10 includes: the clamp voltage control use switch 20; and the clamp voltage decision part 30 where one terminal of the clamp voltage decision part 30 is electrically connected to the drain electrode, and the other end of the clamp voltage decision part 30 is electrically connected with the gate electrode and hence, in the same manner as the conventional switching circuit, the active clamp circuit 10 can absorb a surge voltage. Further, the clamp voltage control use switch 20 has a function of a driver that transmits an ON signal to the gate electrodes G1, G2 of the main switches Q1, Q2 and hence, a drive current is small, and at the same time, a current that flows into the clamp voltage decision part 30 that decides an OFF voltage that becomes a trigger can be made small. Further, the main switches Q1, Q2 can be utilized as current paths for voltage clamp during a period that a surge is generated when the clamping voltage control use switch or the main switch is turned on and hence, it is unnecessary to use a large-sized diode.

Fig. 6 is a schematic graph illustrating the relationship between a clamp voltage and a diode current in the active clamp circuit according to the embodiment 1 and a conventional second active clamp circuit. A broken line in Fig. 6 indicates the relationship between a clamp voltage and a diode current in the conventional active clamp circuit, a solid line indicates the relationship between a clamp voltage and a diode current in the active clamp circuit according to the embodiment 1.

In the conventional second active clamp circuit 910, clamp is performed by bypassing a current the flows into the main switch Q1 and hence, a current that flows into the Zener diode 943 is increased whereby an operation resistance (impedance) of the Zener diode is increased. Accordingly, a change in a clamp voltage (see a curve indicated by a broken like in Fig. 6) caused by the operation resistance (impedance) of the Zener diode is increased. Further, the rise in temperature of the Zener diode is increased and hence, a change in a clamp voltage is increased. Accordingly, it is difficult to make the clamp circuit to operate a function of clamping a surge voltage as designed and hence, it is difficult to make an operation of the switching circuit stable. On the other hand, the active clamp circuit 10 according to the embodiment 1 includes the clamp voltage control use switch 20 and the clamp voltage decision part 30 and hence, a current that flows into the clamp voltage decision part 30 and the Zener diode 33 becomes small and hence, an operation resistance (impedance) of the Zener diode 33 becomes small. Accordingly, a change in a clamp voltage caused by the operation resistance (impedance) of the Zener diode 33 (see a solid line in Fig. 6) can be made small. Further, a current that flows into the clamp voltage decision part 30 and the Zener diode 33 becomes small and hence, the rise in temperature of the Zener diode becomes small whereby a change in a clamp voltage can be made small. Accordingly, a function of clamping a surge voltage can be operated as designed and hence, it is possible to make the operation of the switching circuit stable.

Further, according to the active clamp circuit 10 of the embodiment1, the active clamp circuit 10 possesses the temperature characteristic adjustment resistor 32 and hence, an effect of lowering a forward voltage of the diode 34 that has a characteristic of being decreased with the rise in temperature and an effect of increasing a resistance value of the temperature characteristic adjustment resistor 32 that has a characteristic of being increased with respect to the rise of temperature can cancel each other whereby a change based on temperature of a clamp voltage can be suppressed (see Fig. 6).

Further, according to the active clamp circuit 10 of the embodiment1, the gate protection part 40 has sets each formed of the gate protection use Zener diode 43 and the gate protection use diode 44 that are connected with each other in opposite polarities. Accordingly, it is possible to prevent the occurrence of a phenomenon that an error signal is transmitted to the gate electrode due to a surge voltage generated at the time of switching and, at the same time, it is possible to increase a breakdown strength.

Further, according to the active clamp circuit 10 of the embodiment 1, each set 41 of the gate protection part 40 has the structure where the gate protection use temperature characteristic adjustment resistor 42 is disposed between the gate protection use Zener diode 43 and the gate protection use diode 44 and hence, a change in clamp voltage accompanying a change based on temperature in the gate protection part 40 can be also absorbed. As a result, the gate is minimally broken even when a change based on temperature occurs.

Further, according to the active clamp circuit 10 of the embodiment 1, the temperature characteristic adjustment resistor 32 has a temperature characteristic that reduce a change based on temperature of a voltage obtained by superposing Zener voltage of the Zener diode 33 of the set 31 having the temperature characteristic adjustment resistor 32 and a forward voltage of the diode 34. Accordingly, it is possible to make an effect of lowering the forward voltage of the diode having a characteristic of being decreased with respect to the rise of a temperature and an effect of the rise of a resistance value of the resistor having a characteristic of being increased with respect to the rise based on temperature cancel each other. Further, the temperature characteristic adjustment resistor 32 can cope with the temperature characteristic of the Zener voltage of the Zener diode 33, and can surely suppress a change based on temperature of a clamp voltage of the set 31.

According to the semiconductor device 100 of the embodiment 1, the MOS structure is formed in the region where the source electrode 130 is formed, and the clamp voltage decision part 180 where the plurality of N-type regions 182 and the plurality of P-type regions 184 are alternately disposed adjacently to each other is formed in the withstand voltage separation region A2. The active clamp circuit is constituted of: the clamp voltage control use switch; and the clamp voltage decision part where one terminal of the clamp voltage decision part is electrically connected to the first main electrode of the clamp voltage control use switch and the other end of the clamp voltage decision part is electrically connected to the control electrode of the clamp voltage control use switch. Accordingly, the active clamp circuit can absorb a surge voltage. Further, this clamp voltage control use switch (MOS structure) has a function of performing as a driver for transmitting an ON signal to the control electrode of the main switch and hence, a drive current is small, and a current that flows into a clamp voltage decision part that decides an OFF voltage that becomes a trigger can be also made small. Accordingly, the main switch can be used as a current path for voltage clamping only during a period in which a surge is generated and hence, it is unnecessary to use a large-sized diode.

According to the semiconductor device 100 of the embodiment 1, the MOS structure is formed in the region where the source electrode 130 is formed, and the clamp voltage decision part 180 where the plurality of N-type regions 182 and the plurality of P-type regions 184 are alternately disposed adjacently to each other is formed in the withstand voltage separation region A2. Accordingly, the clamp voltage control use switch 20 and the clamp voltage decision part 30 of the active clamp circuit can be formed. Accordingly, a current that flows into the active clamp circuit 10 and the Zener diode becomes small and hence, an operation resistance (impedance) of the Zener diode 33 becomes small whereby a change in a clamp voltage (indicated by a broken line in Fig. 6) caused by the operation resistance (impedance) of the Zener diode 33 can be made small. Further, the current that flows into the active clamp circuit 10 and the Zener diode 33 becomes small and hence, the rise of temperature of the Zener diode 33 becomes small whereby a change in clamp voltage can be made small. Accordingly, the active clamp circuit can perform a function of clamping a surge voltage as designed and hence, an operation of the switching circuit can be made stable.

Further, according to the semiconductor device 100 of the embodiment 1, in the clamp voltage decision part 180, a total dopant amount in the first P-type region 184 that is sandwiched between two first N-type regions 182 is smaller than a total dopant amount in one of two first N-type regions 182 disposed adjacently to the first P-type region 184, and is also smaller than a total dopant amount in the other of two first N-type regions 182 disposed adjacently to the first P-type region 184. Accordingly, the inner resistance in the P-type region 184 can be set larger than the inner resistance in the first N-type region 182, and the inner resistance in the first P-type region 184 can be set as a temperature characteristic adjustment resistance of the clamp voltage decision part 180. Accordingly, an effect of a temperature characteristic of the inner resistance (characteristic that the inner resistance is decreased with respect to the rise of temperature) of a forward voltage of a diode formed between the first P-type region 184 and the first N-type region 182 can be cancelled by a temperature characteristic of the inner resistance (characteristic that the inner resistance is increased with respect to the rise of temperature) of the first P-type region 184 and hence, a change based on temperature of a clamp voltage can be suppressed.

Further, according to the semiconductor device 100 of the embodiment 1, as viewed in a plan view, in a region that surrounds the gate pad 140 on the field insulation film 170, the semiconductor device 100 includes the gate protection part 142 where at least one second N-type region 143 and at least two second P-type regions 144 are alternately arranged adjacently to each other and hence, a breakdown strength can be increased. Further, although there is a possibility that an electrostatic breakdown strength of a gate voltage is decreased corresponding to downsizing of the device, the semiconductor device 100 includes the gate protection part 142 and hence, an electrostatic breakdown strength can be maintained even when the device is made small.

Further, according to the semiconductor device 100 of the embodiment 1, a total dopant amount of the second P-type region 144 sandwiched between two second N-type regions 143 is smaller than a total dopant amount of one of two second N-type regions 143 disposed adjacently to the second P-type region 144, and is also smaller than a total dopant amount of the other of two second N-type regions 143 disposed adjacently to the second P-type region 144 and hence, the inner resistance of the second P-type regions 144 can be increased, and the inner resistance of the second P-type region 144 becomes the gate protection use temperature characteristic adjustment resistor. Accordingly, an effect of a temperature characteristic of the inner resistance (characteristic that the inner resistance is decreased with respect to the rise of temperature) of a forward voltage of a diode formed between the second P-type region 144 and the second N-type region 143 can be cancelled by a temperature characteristic of the inner resistance (characteristic that the inner resistance is increased with respect to the rise of temperature) of the second P-type region 144 and hence, a change based on temperature of a protective voltage of the gate protection part 142 can be suppressed.

Further, according to the semiconductor device 100 of the embodiment 1, in the clamp voltage decision part 180, the inner resistance of the first P-type regions 184 has a temperature characteristic that cancels a change based on temperature of a voltage that is obtained by superposing a forward voltage of the diode that is formed of the first P-type regions 184 and the first N-type region 182 disposed adjacently to one side of the first P-type regions 284 and a Zener voltage of the Zener diode that is formed of the first P-type regions 184 and the first N-type region 182 disposed adjacently to the first P-type regions 184. Accordingly, a change made by temperature of a clamp voltage can be suppressed with higher accuracy.

Further, according to the semiconductor device 100 of the embodiment 1, the clamp voltage decision part 180 surrounds the whole circumference of the device region A1 as viewed in a plan view. Accordingly, a cross-sectional area (a cross-sectional area from the center toward an outer peripheral side) of a current path is increased and hence, it is possible to allow the flowing of a relatively large current. Accordingly, the impedance is reduced and hence, it is possible the minimize the increase of a clamp voltage. As a result, it is possible to apply a clamp voltage in a more desired range.

In a case where a plurality of P-type guard rings are formed on a surface of the semiconductor base body 110 in the withstand voltage separation region A2, there is a possibility that sparse and dense electric fields are generated attributed to liability of the occurrence of electric field concentration in regions having no guard rings between the guard rings disposed adjacently to each other thus lowering a peripheral withstand voltage. To prevent the occurrence of such a phenomenon, it is necessary to narrow a distance between the guard rings. However, it is difficult to form the guard rings at a fine pitch from a practical point of view, and there arises a problem that there is a possibility that such guard rings affect a Zener voltage of the clamp voltage decision part 180 on the field insulation film 170. To overcome such a problem, according to the semiconductor device 100 of this embodiment, in the withstand voltage separation region A2, a P-type resurf region is formed on the surface of the semiconductor base body 110 and hence, the potential distribution becomes gentle whereby the electric field concentration minimally occurs whereby a stable peripheral withstand voltage can be acquired.

Further, according to the semiconductor device 100 of the embodiment 1, a P-type boundary semiconductor region 118 is formed so as to cover a boundary between the base region 113 and the resurf region 116 and hence, the potential distribution in the vicinity of the boundary between the device region A1 and the withstand voltage separation region A2 becomes gentle whereby a withstand voltage can be easily maintained. Further, the P-type boundary semiconductor region 118 is formed to a position at the same depth as a position of the resurf region 116 or to a position deeper than a position of the resurf region 116 and hence, the potential distribution in the vicinity of the boundary becomes more gentle and hence, a withstand voltage can be more easily maintained.

Further, according to the semiconductor device 100 of the embodiment 1, in the clamp voltage decision part 180, the dopant concentration in the first P-type region 184 sandwiched by two first N-type regions 182 is smaller than the dopant concentration in one of two first N-type regions 182 disposed adjacently to the first P-type region 184, and is also smaller than the dopant concentration in the other of two first N-type regions 182 disposed adjacently to the first P-type region 184 and hence, a total dopant amount in the first P-type region 184 can be made small whereby the resistance value of the inner resistance of the first P-type region 184 can be made small.

### [Embodiment 2]

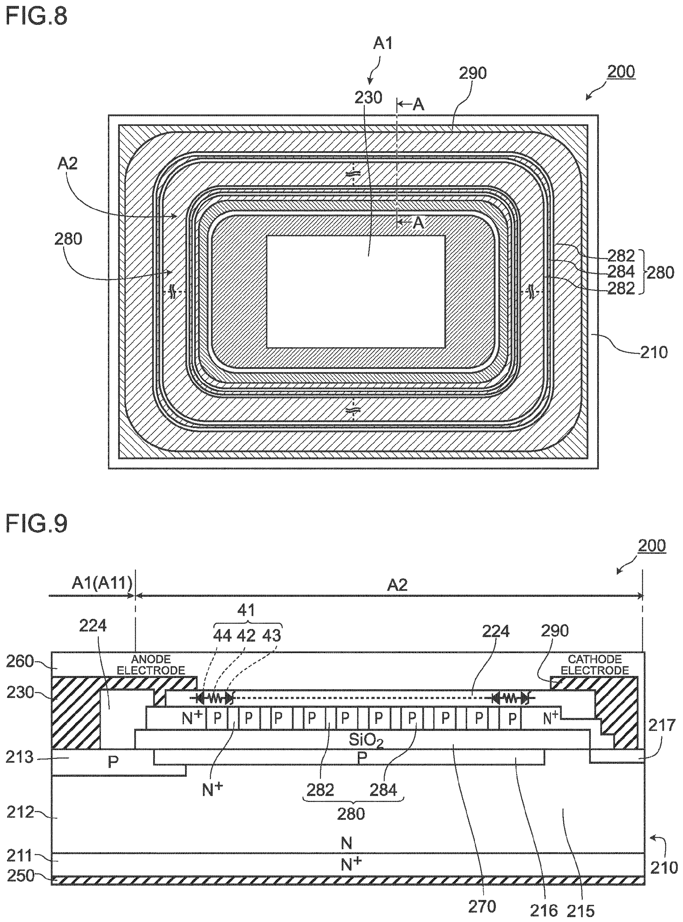

Fig. 7 is a circuit diagram illustrating an active clamp circuit 10a in the embodiment 2. Fig. 8 is a plan view provided for describing a semiconductor device 200 according to the embodiment 2. Fig. 9 is a cross-sectional view provided for describing the semiconductor device 200 according to the embodiment 2. In Fig. 9, symbol 213 indicates an anode region, symbol 230 indicates an anode electrode, and symbol 250 indicates a cathode electrode.

The active clamp circuit 10a and the semiconductor device 200 according to the embodiment 2 basically have substantially the same configuration as the active clamp circuit 10 and the semiconductor device 100 according to the embodiment 1. However, the active clamp circuit 10a and the semiconductor device 200 according to the embodiment 2 differ from the active clamp circuit 10 and the semiconductor device 100 according to the embodiment 1 with respect to a point that the active clamp circuit 10a and the semiconductor device 200 according to the embodiment 2 include a bypass diode in place of the clamp voltage control use switch (see Fig. 7 to Fig.9). The active clamp circuit 10a according to the embodiment 2 has neither the gate protection part 40 nor the resistor 50.

The bypass diode 60 includes an anode electrode A and a cathode electrode K, the anode electrode A is electrically connected with a gate electrode G1 of a main switch Q1, and the cathode electrode K is electrically connected with a drain electrode D1 of the main switch Q1. A clamp voltage decision part 30 is configured such that one terminal of the clamp voltage decision part 30 is electrically connected with the cathode electrode K of the bypass diode 60, and the other terminal of the clamp voltage decision part 30 is electrically connected with the anode electrode A of the bypass diode 60.

The semiconductor device 200 according to the embodiment 2 includes none of a gate pad 140, a first gate wiring 145 and a second gate wiring 147 in a device region A1 (see Fig. 8).

In the device region A1, as illustrated in Fig. 9, a semiconductor base body 210 includes a low resistance semiconductor layer 211, an N-type semiconductor region 212 (a drift layer), and a P-type anode region 213. Further, the semiconductor base body includes a diode structure between an anode region 213 and a drift layer 212.

In a withstand voltage separation region A2, the clamp voltage decision part 280 is configured such that, a plurality of N-type regions 282 and a plurality of P-type regions 284 are alternately disposed adjacently to each other on a field insulation film 270, the N-type region 282 disposed nearest to the device region A1 is electrically connected with the anode electrode, and the N-type region 282 remotest from the device region A1 is electrically connected with the cathode electrode.

In this manner, the active clamp circuit 10a and the semiconductor device 200 according to the embodiment 2 differs from the active clamp circuit 10 and the semiconductor device 100 according to the embodiment 1 with respect to the point that the semiconductor device 200 includes the bypass diode in place of the clamp voltage control use switch. However, the active clamp circuit 10a includes: the bypass diode 60; and the clamp voltage decision part 30 that is configured such that one terminal of the clamp voltage decision part 30 is electrically connected with the cathode electrode K of the bypass diode 60, and the other terminal of the clamp voltage decision part 30 is electrically connected with the anode electrode A of the bypass diode 60. Accordingly, a voltage can be clamped by absorbing a surge voltage. Further, a current that flows into the clamp voltage decision part 30 can be made small and, at the same time, the main switch can be used as a current path for voltage clamping during a period that a surge occurs by turning on the main switch and hence, it is unnecessary to use a large-sized diode.

According to the semiconductor device 200 of the embodiment 2, the diode structure is formed in the region where the anode electrode 230 is formed, and the semiconductor device 200 includes the clamp voltage decision part 280 where a plurality of first P-type regions 284 and a plurality of first N-type 282 are alternately disposed adjacently to each other. Accordingly, the semiconductor device 200 can provide the active clamp circuit 10a that includes: the bypass diode 60; and the clamp voltage decision part 30 where one terminal of the clamp voltage decision part 30 is electrically connected with the anode electrode A of the bypass diode 60 and the other terminal of the clamp voltage decision part 30 is electrically connected with the cathode electrode K of the bypass diode 60. Accordingly, a voltage can be clamped by absorbing a surge voltage. Further, a current that flows into the clamp voltage decision part 30 can be made small and, at the same time, the main switch can be used as a current path for voltage clamping during a period that a surge voltage occurs by turning on the main switch and hence, it is unnecessary to use a large-sized diode.

The active clamp circuit 10a and the semiconductor device 200 according to the embodiment 2 basically have substantially the same configuration as the active clamp circuit 10 and the semiconductor device 100 according to the embodiment 1 except for the point that the active clamp circuit 10a and the semiconductor device 200 according to the embodiment 2 has the bypass diode in place of the clamp voltage control use switch. Accordingly, the active clamp circuit 10a and the semiconductor device 200 of the embodiment 2 acquires advantageous effects that are equal to the advantageous effects of the active clamp circuit 10 and the semiconductor device 10 of the embodiment 1 amongst all advantageous effects acquired by the active clamp circuit 10 and the semiconductor device 100 of the embodiment 1.

### [Embodiment 3]

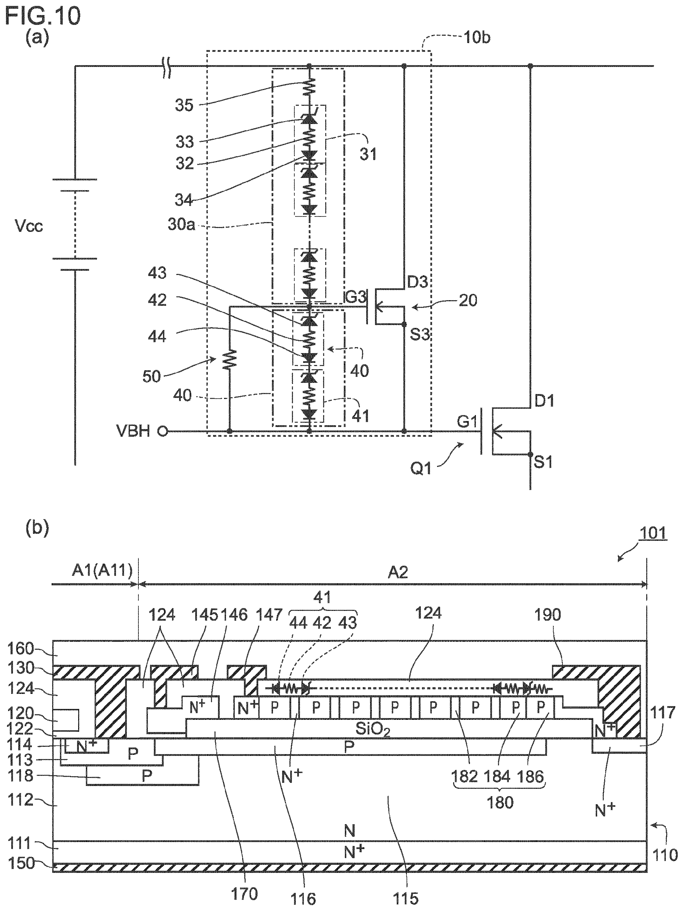

Fig. 10 is a view provided for describing an active clamp circuit 10b and a semiconductor device 101 according to an embodiment 3. Fig. 10(a) is a circuit diagram for describing the active clamp circuit 10b, and Fig. 10(b) is a cross-sectional view for describing the semiconductor device 101.

The active clamp circuit 10b according to the embodiment 3 basically has substantially the same configuration as the active clamp circuit 10 according to the embodiment 1. However, the active clamp circuit 10b according to the embodiment 3 differs from the active clamp circuit 10 according to the embodiment 1 with respect to a point that the active clamp circuit 10b according to the embodiment 3 includes a second temperature characteristic adjustment resistor (see Fig. 10(a)). That is, a clamp voltage decision part 30a includes a second temperature characteristic adjustment resistor 35 that adjusts a temperature characteristic on a drain electrode D1 side of a main switch Q1. Although the second temperature characteristic adjustment resistor 35 is disposed on the drain electrode D1 side of the main switch Q1, the second temperature characteristic adjustment resistor 35 may be disposed on a gate electrode G3 side of the clamp voltage control use switch 20, or may be disposed between a set 31 and a set 31. Further, the second temperature characteristic adjustment resistor 35 may be disposed at two or more places.

In the clamp voltage decision part 30a according to the embodiment 3, a temperature characteristic adjustment resistor 32 and the second temperature characteristic adjustment resistor 35 has a temperature characteristic of reducing a change made by a temperature of a forward voltage of a diode 34. To be more specific, in the clamp voltage decision part 30, a change made by temperature of a forward voltage of the diode 34 and a change made by temperature of a Zener voltage of a Zener diode 33 can be adjusted to desired temperature coefficients based on a product resistance obtained from the temperature characteristic adjustment resistor 32 and the second temperature characteristic adjustment resistor 35. With such adjustment, change amounts of threshold voltages VTH of main switches Q1, Q2 brought about by a change in temperature can be cancelled each other.

The semiconductor device 101 according to the embodiment 3 basically have substantially the same configuration as the semiconductor device 100 according to the embodiment 1. However, the semiconductor device 101 according to the embodiment 3 differs from the semiconductor device 100 according to the embodiment 1 with respect to a point that the semiconductor device 101 according to the embodiment 3 includes the second temperature characteristic adjustment resistor (see Fig.10(b)). That is, a clamp voltage decision part 180 further includes a second P-type region 186 that adjusts a temperature characteristic on an outer peripheral side end portion thereof.

The second P-type region 186 may be disposed on a device region A1 side, or may be disposed as a suitable position of the clamp voltage decision part 180. Further, the second P-type region 186 may surround the whole circumference of the device region A1, or may be partially formed so as to adjust a resistance component. Further, the second P-type region 186 may be formed using additives or other materials different from the materials used in the first P-type region.

In this manner, the active clamp circuit 10b (semiconductor device 101) according to the embodiment 3 differs from the active clamp circuit 10 (semiconductor device 100) according to the embodiment 1 with respect to the point that the active clamp circuit 10b (semiconductor device 101) according to the embodiment 3 has the second temperature characteristic adjustment resistor 35 (second P-type region 186). On the other hand, the active clamp circuit 10b (semiconductor device 101) according to the embodiment 3 includes: a clamp voltage control use switch 20; and the clamp voltage decision part 30 where one terminal of the clamp voltage decision part 30 is electrically connected to a drain electrode and the other terminal of the clamp voltage decision part 30 is electrically connected to a gate electrode. Accordingly, a surge voltage can be absorbed. Further, this clamp voltage control use switch 20 has a function of performing as a driver for transmitting an ON signal to the gate electrodes G1, G2 of the main switches Q1, Q2 and hence, a drive current is small, and a current that flows into a clamp voltage decision part that decides an OFF voltage that becomes a trigger can be also made small. On the other hand, the main switch can be used as a current path for voltage clamping only during a period in which a surge is generated by turning on the clamp voltage control use switch or the main switches and hence, it is unnecessary to use a large-sized diode.

The clamp voltage decision part 30 includes the second temperature characteristic adjustment resistor 35 that adjust the temperature characteristic and hence, the clamp voltage decision part 30 can perform not only the reduction of temperature dependency of the clamp voltage by the temperature characteristic adjustment resistor 32 but also the adjustment of the second temperature characteristic adjustment resistor 35 so as to impart a temperature characteristic of canceling the temperature dependency of the threshold voltages VTH of the main switches Q1, Q2 to the second temperature characteristic adjustment resistor 35. With such a configuration, it is possible to cancel the temperature dependency of the clamp voltage of the clamp voltage control use switch 20 and the temperature dependency of the threshold voltage values VTH of the main switches Q1, Q2.

The active clamp circuit 10b (the semiconductor device 101) according to the embodiment 3 basically has substantially the same configuration as the active clamp circuit 10 (the semiconductor device 100) according to the embodiment 1 except for the point that the active clamp circuit 10c according to the embodiment 3 has the second temperature characteristic adjustment resistor 35 (the second P-type region 186). Accordingly, the active clamp circuit 10b of the embodiment 3 acquires advantageous effects that are equal to the advantageous effects of the active clamp circuit 10 of the embodiment 1 amongst all advantageous effects acquired by the active clamp circuit 10 of the embodiment 1.

Heretofore, the present invention has been described with reference to the above-mentioned embodiments. However, the present invention is not limited to the above-mentioned embodiments, and can be carried out in various modes without departing from the gist of the present invention and, for example, the following modifications are conceivable.
(1) The positions, the connections, the number of constitutional elements and the like described in the above-mentioned respective embodiments are described in an exemplified manner, and can be changed within a scope that advantageous effects of the present invention are not impaired.
(2) In the above-mentioned respective embodiments, the inner resistance is adjusted by performing the adjustment of a total dopant amount by adjusting a dopant concentration in the first P-type region and a length along a current path. However, the present invention is not limited to such a case. The inner resistance may be adjusted by performing the adjustment of a total dopant amount by adjusting either one of the dopant concentration in the first P-type region or the length along the current path, or a total dopant amount may be adjusted by adjusting a cross-sectional area of a surface perpendicular to a current path. To be more specific, the first P-type region may not be formed along the whole circumference of the device region A1 and may be formed on a partial circumference of the device region A1. Further, the internal resistance may be adjusted by introducing a different material or by incorporating different additives.
(3) In the above-mentioned embodiments 1 and 3, the gate protection part is provided. However, the present invention is not limited to such a configuration. The gate protection part may not be provided. Further, as the resistor of the gate protection part, the temperature characteristic adjustment resistor is used. However, a general-use resistor that is not a resistor whose temperature characteristic is adjusted may be used, or a resistor may not be used.
(4) In the above-mentioned respective embodiments, the base region 113 and the resurf region 116 abut against each other, and the boundary semiconductor region 118 is formed so as to cover the boundary between the base region 113 and the resurf region 116. The present invention is not limited to such a configuration. The base region 113 and the resurf region 116 may not abut against each other. In this case, the boundary semiconductor region 118 may be formed between the base region 113 and the resurf region 116. In this case, it is preferable that a depth of the boundary semiconductor region 118 be equal to deeper than a depth of the resurf region 116. With such a configuration, the potential distribution in the vicinity of the boundary between the device region A1 and the withstand voltage separation region A2 becomes gentle and hence, a withstand voltage can be easily maintained.
(5) In the above-mentioned respective embodiments, the gate protection part is provided. However, the present invention is not limited to such a configuration. The gate protection part may not be provided. Further, although the temperature characteristic adjustment resistor is used as the resister of the gate protection part. However, a general-use resistor that is not a resister whose temperature characteristic is not adjusted may be used, or a resistor may not be used.

### [Reference Signs List]

1: switching circuit
10, 10a, 10b: active clamp circuit
20: clamp voltage control use switch
30, 30a: clamp voltage decision part
31: set
32: temperature characteristic adjustment resistor
33: Zener diode
34: Zener diode
35: second temperature characteristic adjustment resistor
40: gate protection part
41: set
42: temperature characteristic adjustment resistor
43: Zener gate protection use diode
44: diode
50: resistor
60: bypass diode
100, 101, 200: semiconductor device
110: semiconductor base body
111, 211: low resistance semiconductor layer
112, 212: drift layer
113: base region
114: source region
115: N-type semiconductor layer
116: resurf region
117: channel stop region
118: boundary semiconductor region
119: P-type semiconductor layer
120: gate electrode
122: gate insulation film
124: interlayer insulation film
130: source electrode
140: gate pad
141: polysilicon layer
142: gate protection part
143: second N-type region
144: second P-type region
145: gate wiring
146: gate lead wiring
147: second gate wiring
150: drain electrode
160: protection insulation film
170, 270: field insulation film
172: polysilicon layer
180,280: clamp voltage decision part
182: 282: first N-type region
184: 284: first P-type region
186: third P-type region
190: channel stopper electrode
213: anode region
230: anode electrode
A1: device region
A11: active region
A12: peripheral region
A2: withstand voltage separation region
Q1: first main switch
Q2: second main switch
Vcc: external power source

## Claims

1. An active clamp circuit that is connected between a control electrode and a main electrode of a main switch and is configured to control a clamp voltage of the main switch, the active clamp circuit comprising:
a clamp voltage control use switch that includes a first main electrode, a second main electrode and a control electrode, wherein the second main electrode is electrically connected with the main electrode of the main switch, the first main electrode is electrically connected with the control electrode of the main switch, and
a clamp voltage decision part where one terminal of the clamp voltage decision part is electrically connected to the second main electrode of the clamp voltage control use switch and an other terminal of the clamp voltage decision part is electrically connected to the control electrode of the clamp voltage control use switch, wherein
the clamp voltage decision part includes a plurality of sets each being constituted of a temperature characteristic adjustment resistor, a Zener diode connected to one end of the temperature characteristic adjustment resistor, and a diode connected to an other end of the temperature characteristic adjustment resistor such that the diode has an opposite characteristic with respect to the Zener diode, the sets being connected in series.

2. The active clamp circuit according to claim 1, further comprising a gate protection part where one end of the gate protection part is connected to the control electrode of the clamp voltage control use switch and the other end of the gate protection part is electrically connected to the control electrode of the main switch and the first main electrode of the clamp voltage control use switch, wherein
the gate protection part has at least one set where at least a gate protection Zener diode and a gate protection use diode are connected with each other with opposite polarities.

3. The active clamp circuit according to claim 2, wherein the each set of the gate protection part has a structure where a gate protection use temperature characteristic adjustment resistor is electrically connected between the gate protection use Zener diode and the gate protection use diode.

4. An active clamp circuit that is connected between a control electrode and a main electrode of a main switch and is configured to control a clamp voltage of the main switch, the active clamp circuit comprising:
a bypass diode that includes an anode electrode and a cathode electrode, wherein the anode electrode is electrically connected with the control electrode of the main switch, and the cathode electrode is electrically connected with the main electrode of the main switch, and
a clamp voltage decision part where one terminal of the clamp voltage decision part is electrically connected to the cathode electrode of the bypass diode and an other terminal of the clamp voltage decision part is electrically connected to the anode electrode of the bypass diode and the control electrode of the main switch, wherein
the clamp voltage decision part includes a plurality of sets each being constituted of a temperature characteristic adjustment resistor, a Zener diode connected to one end of the temperature characteristic adjustment resistor, and a diode connected to an other end of the temperature characteristic adjustment resistor such that the diode has an opposite characteristic with respect to the Zener diode, the sets being connected in series.

5. The active clamp circuit according to any one of claims 1 to 4, wherein the temperature characteristic adjustment resistor has a temperature characteristic of reducing a change based on temperature of a voltage obtained by superposing a Zener voltage of the Zener diode of the set having the temperature characteristic adjustment resistor, and a forward voltage of the diode.

6. The active clamp circuit according to any one of claims 1 to 4, wherein the clamp voltage decision part includes a second temperature characteristic adjustment resistor that adjusts a temperature characteristic at least either one of at an end or between two sets disposed adjacently to each other.

7. A semiconductor device that forms an active clamp circuit that is connected between a control electrode and a main electrode of a main switch and is configured to control a clamp voltage of the main switch, and is formed on a semiconductor base body on which a device region and a withstand voltage separation region that is formed around the device region are defined from each other, wherein
the semiconductor device includes, in the device region,
the semiconductor base body,
a first main electrode that is formed on a surface of the semiconductor base body on a front surface side,
a gate pad that is formed on the surface of the semiconductor base body on the front surface side, and is spaced apart from the first main electrode, and
a second main electrode that is formed on a surface of the semiconductor base body on a back surface side,
the semiconductor device includes an MOS structure that is formed in a region in which the first main electrode is formed, and
the semiconductor device includes, in the withstand voltage separation region,
the semiconductor base body,
the second main electrode that is formed on the surface of the semiconductor base body on the back surface side,
an insulation film formed on the surface of the semiconductor base body,
a clamp voltage decision part where, on the insulation film, in a region that surrounds the device region as viewed in a plan view, a plurality of first first-conductive-type region and a plurality of first second-conductive-type region are alternately disposed adjacently to each other, wherein one end of the clamp voltage decision part is electrically connected to the gate pad, and the other end of the clamp voltage decision part is electrically connected to the second main electrode, and
in the clamp voltage decision part, a total dopant amount of the first first-conductive-type region sandwiched by the two first second-conductive-type regions is smaller than a total dopant amount of one of the two first second-conductive-type regions disposed adjacently to the first first-conductive-type region, and is also smaller than a total dopant amount of the other of the two first second-conductive-type regions disposed adjacently to the first first-conductive-type region.

8. The semiconductor device according to claim 7, further comprising, in a region that surrounds the gate pad on the insulation film as viewed in a plan view, a gate protection part where at least one second first-conductive type region and at least two second second-conducive-type regions are alternately disposed adjacently to each other.

9. The semiconductor device according to claim 8, wherein in the gate protection part, a total dopant amount in the second first-conductive-type region sandwiched between the two second second-conductive-type regions is smaller than a total dopant amount of one of the two second second-conductive-type conductive regions disposed adjacently to the second first-conductive-type region, and is also smaller than a total dopant amount of the other of the two second second-conductive-type conductive regions disposed adjacently to the second first-conductive-type region.

10. A semiconductor device that forms an active clamp circuit that is connected between a control electrode and a main electrode of a main switch and is configured to control a clamp voltage of the main switch, and is formed on a semiconductor base body on which a device region and a withstand voltage separation region that is formed around the device region are defined from each other, wherein
the semiconductor device includes, in the device region,
the semiconductor base body,
a first main electrode that is formed on a surface of the semiconductor base body on a front surface side, and
a second main electrode that is formed on a surface of the semiconductor base body on a back surface side,
a diode structure that is formed in a region in which the first main electrode is formed, and
the semiconductor device includes, in the withstand voltage separation region,
the semiconductor base body,
the second main electrode that is formed on the surface of the semiconductor base body on the back surface side, and
an insulation film formed on the surface of the semiconductor base body, and
a clamp voltage decision part where, on the insulation film, in a region that surrounds the device region as viewed in a plan view, a plurality of first first-conductive-type region and a plurality of first second-conductive-type region are alternately disposed adjacently to each other, wherein one end of the clamp voltage decision part is electrically connected to the first main electrode, and the other end of the clamp voltage decision part is electrically connected to the second main electrode, and
in the clamp voltage decision part, a total dopant amount of the first first-conductive-type region sandwiched by the two first second-conductive-type regions is smaller than a total dopant amount of one of two first second-conductive-type regions disposed adjacently to the first first-conductive-type region, and is also smaller than a total dopant amount of the other of two first second-conductive-type regions disposed adjacently to the first first-conductive-type region.

11. The semiconductor device according to any one of claims 7 to 10, wherein in the clamp voltage decision part, an inner resistor of the first first-conductive-type region sandwiched by two first second-conductive-type regions has a temperature characteristic of canceling a change based on temperature of a voltage obtained by superposing a forward voltage of a diode formed of the first first-conductive-type region and the first second-conductive-type region disposed adjacently to one side of the first first-conducive-type region and a Zener voltage of a Zener diode formed of the first first-conductive-type region and the first second-conductive-type region disposed adjacently to an other side of the first first-conductive type region.

12. The semiconductor device according to any one of claims 7 to 10, wherein the clamp voltage decision part surrounds the whole circumference of the device region as viewed in a plan view.

13. The semiconductor device according to any one of claims 7 to 10, wherein in the withstand voltage separation region, a first-conductive type resurf region is formed on a surface of the semiconductor base body.

14. The semiconductor device according to claim 13, wherein a surface first-conductive-type region is formed on a surface of the device region, and
a boundary semiconductor region of a first-conductive-type is formed so as to cover a boundary between the surface first-conductive-type region and the resurf region.

15. The semiconductor device according to claim 13, wherein a surface first-conductive-type region is formed on a surface of the device region, and
between the surface first-conductive-type region and the resurf region, a boundary semiconductor region that is formed to a depth position equal to positions of either one of the surface first-conductive-type region and a resurf region of the semiconductor base body or deeper than either one of the first-conductive-type region and the resurf region of the semiconductor base body is formed.

16. The semiconductor device according to any one of claims 7 to 10, wherein in the clamp voltage decision part, a dopant concentration of the first first-conductive-type region sandwiched between the two first second-conductive-type region is smaller than either one of the first first-conductive-type region and the two first second-conductive-type region disposed adjacently to the first first-conductive-type region.

17. The semiconductor device according to any one of claims 7 to 10, wherein in the clamp voltage decision part, a third first-conductive-type region that adjust a temperature characteristic is disposed in at least any one of an end portion of the clamp voltage decision part or between the sets disposed adjacently to each other.
